# EUROPÄISCHE PATENTANMELDUNG

(11) **EP 1 205 977 A2**
(43) Veröffentlichungstag der Anmeldung: **15.05.2002**
(21) Anmeldenummer: 01126398.5
(22) Anmeldetag: 07.11.2001
(51) Int. Cl.: H01L 27/108, H01L 23/485

(54) **Speicheranordnung mit einem zentralen Anschlussfeld**

(30) Priorität: 07.11.2000 DE 10055001
(71) Anmelder: Infineon Technologies AG, 81669 München (DE)
(72) Erfinder: Brox, Martin, 80636 München (DE); Kaiser, Robert, 86916 Kaufering (DE); Pfefferl, Karl-Peter, 85635 Höhenkirchen-Siegertsbrunn (DE); Savignac, Dominique, 85737 Ismaning (DE); Schneider, Helmut, 80993 München (DE)
(74) Vertreter: Patentanwaltskanzlei WILHELM & BECK

(57) **Zusammenfassung**

Es wird eine Speicheranordnung beschrieben, die ein zentrales Anschlussfeld (1) aufweist. Das zentrale Anschlussfeld ist kranzförmig von Zellenfeldern (2-9) mit Speicherzellen umgeben. Auf diese Weise wird eine Speicheranordnung mit kompakten Außenmaßen bereitgestellt, die sich insbesondere für ein Seitenverhältnis von 2:1 eignet. Im zentralen Anschlussfeld sind vorzugsweise alle Peripherieschaltungen (23) angeordnet. Dadurch sind die Laufzeitunterschiede zwischen den Peripherieschaltungen und den verschiedenen Zellenfeldern relativ gering.

## Beschreibung

Die Erfindung betrifft eine Speicheranordnung gemäß dem Oberbegriff des Patentanspruchs 1.

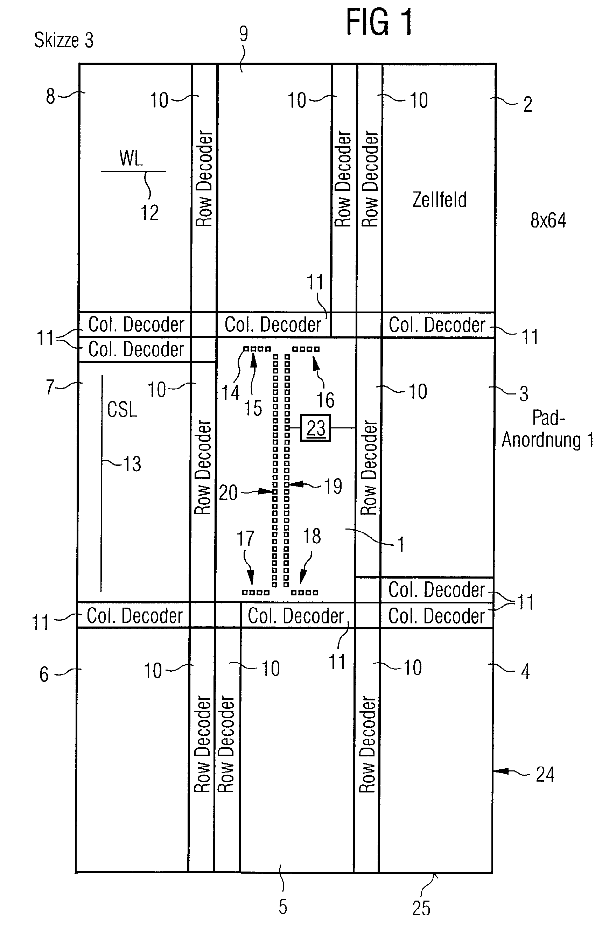

Halbleiterspeicher werden typischerweise aus kleinen, regulären Zelleneinheiten aufgebaut (z.B. bestehen beim 256 Mb-DRAM die Zelleneinheiten aus 4 Mb). Diese Zelleneinheiten werden zu größeren Anordnungen zusammengefasst (Zellenfelder), die beim 256 Mb-DRAM wiederum häufig 64 Mb groß sind. Beim 256 M-DRAM müssen somit vier dieser Zellenfelder auf dem Baustein angeordnet werden, wobei häufig jeweils zwei Zellenfelder nebeneinander angeordnet sind und zwischen zwei nebeneinander angeordneten Zellenfeldern ein Anschlussfeld ausgebildet ist. Das Anschlussfeld weist Bondpads auf, die mit dem Schaltelementen der Zellenfelder verbunden sind und zum Anschluss von weiteren Schaltungen dienen. Da ein einzelnes Zellenfeld häufig ein Seitenverhältnis von 2:1 hat, und das Anschlussfeld relativ klein ist, ergibt sich z. B. bei dem 256 Mb-DRAM mit vier Zellenfeldern direkt ein Gesamt-Seitenverhältnis von 2:1. Bei einem 512 M-DRAM, bei welchem dann acht Zellenfelder (512M = 8*64M) platziert werden müssen, bleiben nun im Stand der Technik zwei Alternativen:
a) vier Zellenfelder nebeneinander (Abb. 1a)
b) jeweils vier Zellenfelder in einer 2*2 Anordnung auf beiden Seiten des Anschlussfeldes (Abb. 1b).
Beide Anordnungen besitzen ein ungünstiges Seitenverhältnis von 4:1 (Fall(a)) oder 1:1 (Fall (b)). Diese Seitenverhältnisse führen unter Umständen zu Chip-Abmessungen, die in standardisierte Gehäuse nicht mehr hineinpassen.

Die Aufgabe der Erfindung besteht darin, Speicherfelder mit einem flexibleren Aufbau bereitzustellen.

Die Aufgabe der Erfindung wird durch die Merkmale des Anspruchs 1 gelöst. Ein wesentlicher Vorteil der Erfindung besteht darin, dass ein mittig angeordnetes Anschlussfeld vorgesehen ist, das ringförmig von Zellenfeldern umgeben ist. Auf diese Weise wird eine sehr kompakte Anordnung einer Vielzahl von Zellenfeldern in einer Speicheranordnung erreicht.

Weitere vorteilhafte Ausführungsformen der Erfindung sind in den abhängigen Ansprüchen angegeben.

Weiterhin ist es vorteilhaft, das Anschlussfeld und die Zellenfelder rechteckförmig auszubilden, wobei an jeder Seitenkante des Anschlussfeldes ein Zellenfeld mit entsprechend großer Seitenkante angrenzt. In den Eckbereichen des Anschlussfeldes ist jeweils ein weiteres Zellenfeld angeordnet. Diese Ausführungsform der Speicheranordnung weist eine rechteckförmige Außenkontur auf. Damit ist die Speicheranordnung für ein Standardgehäuse mit einem Seitenkantenverhältnis von 2:1 besonders geeignet.

Eine vorteilhafte Ausführungsform der Erfindung besteht darin, dass in den Bereichen der Seitenkanten eines Zellenfeldes, das an ein anderes Zellenfeld oder an das Anschlussfeld angrenzt, ein Zeilendecoder oder ein Reihendecoder ausgebildet ist. Auf diese Weise sind der Zeilen- oder Reihendecoder relativ nahe am zentralen Anschlussfeld angeordnet, so dass die Signalwege zum Auslesen oder Einschreiben von Daten in die Zellenfelder relativ kurz sind.

Vorzugsweise weist ein Zellenfeld die annähernd gleiche Größe wie das Anschlussfeld auf.

In einer weiteren Ausführungsform der Erfindung ist jedes Zellenfeld noch einmal in zwei Unterzellenfelder unterteilt.

In einer bevorzugten Ausführungsform sind die Bondpads im Anschlussfeld in Form von vier Reihen angeordnet, wobei die vier Reihen parallel zu den vier Außenkanten des Anschlussfeldes angeordnet sind. Auf diese Weise wird eine symmetrische Verteilung der Anschlusspads ermöglicht.

Weiterhin ist es vorteilhaft, Peripherieschaltungen im zentralen Anschlussfeld anzuordnen. Damit sind die Peripherieschaltungen von allen Zellenfeldern nahezu gleich weit entfernt, so dass Laufzeitunterschiede zwischen den Signalen verschiedener Zellenfelder relativ gering sind.

Die Erfindung wird im folgenden anhand der Figuren näher erläutert. Es zeigen:
- Fig. 1: eine erste Speicheranordnung,
- Fig. 2: eine zweite Ausführungsform einer Speicheranordnung, und
- Fig. 3: eine dritte Ausführungsform einer Speicheranordnung.

Fig. 1 zeigt eine Speicheranordnung, die in der Außenkontur rechteckförmig aufgebaut ist. Eine Längskante 24 der Speicheranordnung ist nahezu doppelt so lang, wie eine Querkante 25 der Speicheranordnung. Somit ist die Speicheranordnung zum Einbau in eine Standardgehäuse mit einem Seitenverhältnis von ungefähr 2:1 geeignet. Dieses Seitenverhältnis wird beispielsweise bei einer Speicherzwischengröße von 128 Megabit, 512 Megabit, 2 Gigabit usw. eingesetzt. Aufgrund der Außenkonturen der Speicheranordnungen ist es möglich, z.B. den 512 Megabit DRAM bereits eine Technologiegeneration früher in ein Standardgehäuse einzubauen als in Architekturen des Standes der Technik.

In der Mitte der Speicheranordnung ist ein Anschlussfeld 1 angeordnet, das rechteckförmig ausgebildet ist. Das Seitenverhältnis des Anschlussfeldes 1 weist ein Verhältnis der Längsseite zur Querseite von ungefähr 2:1 auf. Im Anschlussfeld 1 sind Bondpads 14 ausgebildet, die in Form von Reihen angeordnet sind. Ein Bondpad 14 dient zum Anschluss eines Bonddrahtes, der vom Bondpad zu Anschlusspins eines Gehäuses geführt ist. Die Bondpads sind an Schaltungen und Zellenfelder angeschlossen. Die Reihen 15, 16, 17, 18, 19, 20 sind jeweils parallel und in einem vorgegebenen Abstand zu der Querkante und der Längskante des Anschlussfeldes 1 angeordnet. In dem beschriebenen Ausführungsbeispiel ist eine erste und zweite Reihe 15, 16 in einem vorgegebenen Abstand zur oberen Querkante des Anschlussfeldes 1 angeordnet, wobei die erste und die zweite Reihe 15, 16 wiederum einen vorgegebenen Abstand zueinander aufweisen und symmetrisch jeweils einen gleichgroßen Abstand zu den zwei Längskanten aufweisen.

Weiterhin ist eine dritte und vierte Reihe 17, 18 ausgebildet, die spiegelsymmetrisch zur ersten und zweiten Reihe 15, 16 im Anschlussfeld 1 angeordnet sind. Eine fünfte und sechste Reihe 20, 19 von Bondpads 14 ist jeweils in einem vorgegebenen Abstand und parallel zu den Längskanten angeordnet. Die fünfte und sechste Reihe 19, 20 sind in dem Zwischenbereich angeordnet, die die erste und zweite bzw. dritte und vierte Reihe 15, 16, 17, 18 beabstandet sind. Auf diese Weise wird eine symmetrische Verteilung der Bondpads 14 erreicht. Damit ist relativ viel Platz für ein Verschweißen der Bondpads 14 mit Bonddrähten gegeben und zudem sind die Zellenfelder nahezu mit einem gleichgroßen Abstand um die Bondpads angeordnet. Es sind jedoch auch andere Anordnungen von Bondpads wie z.B. die Anordnung in einer Reihe möglich.

Das Anschlussfeld 1 ist in Form eines Kranzes mit einem ersten, zweiten, dritten, vierten, fünften, sechsten, siebten, achten Zellenfeld 2, 3, 4, 5, 6, 7, 8, 9 umgeben, wobei die Zellenfelder in der Form und in der Größe entsprechend dem Anschlussfeld 1 ausgebildet sind. Ein Zellenfeld stellt ein matrixförmiges Speicherfeld mit Speicherzellen dar. Zudem ist an jeder Längs- und Querkante des Anschlussfeldes 1 ein Zellenfeld angeordnet, so dass jeweils zwei Zellenfelder 9, 5 mit jeweils einer Querkante an der oberen bzw. unteren Querkante des Anschlussfeldes 1 angrenzen und die Längskanten des vierten und achten Zellenfeldes 5, 9 und des Anschlussfeldes 1 eine gerade Linie bilden. Ein zweites und sechstes Zellenfeld 3, 7 grenzt jeweils mit einer Seitenkante an eine Seitenkante des Anschlussfeldes 1, wobei das zweite und sechste Zellenfeld 3, 7 in der Weise angeordnet sind, dass die Querkanten des zweiten, des sechsten Zellenfeldes und des Anschlussfeldes 1 jeweils eine gerade Linie bilden.

In den Eckbereichen sind ein erstes, drittes, fünftes und siebtes Zellenfeld 2, 4, 6, 8 in der Weise angeordnet, dass die Außenkanten der Zellenfelder eine rechteckförmige Kontur bilden. Die Zellenfelder 2 bis 9 sind identisch aufgebaut. Jedes Zellenfeld weist einen Zeilendecoder 10 mit Zeilenleitungen 12 und einem Spaltendecoder 11 mit Spaltenleitungen 13 auf. Über den Zeilen- und Reihendecoder 10, 11 werden die einzelnen Speicherzellen des Zellenfeldes kontaktiert, die sich an jeweiligen Kreuzungspunkten der Zeilenauswahlleitungen und Reihenauswahlleitungen 12, 13 befinden. Jeder Zeilendecoder 10 und Reihendecoder 11 ist elektrisch mit Bondpads 14 verbunden. Die Zeilendecoder 10 sind entlang den Längskanten in den jeweiligen Zellenfeldern angeordnet. Die Reihendecoder 11 sind angrenzend an die Querkanten im jeweiligen Zellenfeld angeordnet. Die Zeilendecoder 10 und Reihendecoder 11 sind immer an Kanten angeordnet, die an ein Zellenfeld oder ein Anschlussfeld 1 angrenzen. Somit liegen die Zeilendecoder 10 und Reihendecoder 10 relativ nahe am Anschlussfeld 1, so dass die Signalwege zwischen den Zeilendecodern 10, Reihendecodern 11 und den Anschlusspads 14 bzw. den Peripherieschaltung 23 relativ kurz sind.

Das Anschlussfeld 1 weist mehrere Peripherieschaltungen 23 auf, die mit Bondpads 14 und/oder mit den Zellenfeldern elektrisch verbunden sind. Als Peripherieschaltungen sind beispielsweise Verstärkerschaltungen, Kontroll-Logik und weitere Schaltungen vorgesehen, die zum Betreiben der Speicheranordnung notwendig sind.

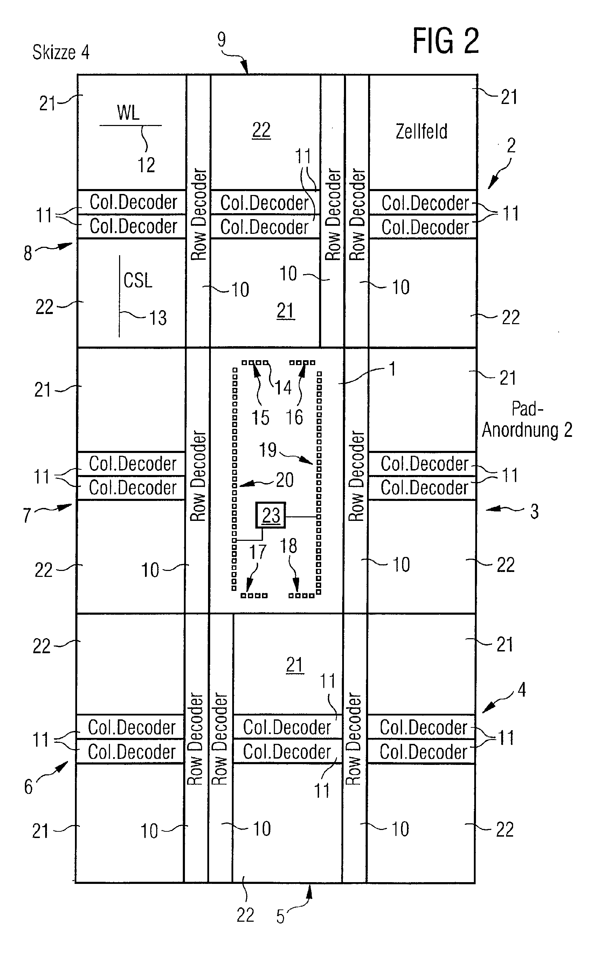

Fig. 2 zeigt eine weitere Ausführungsform einer Speicheranordnung, bei der im Vergleich zu der Speicheranordnung der Fig. 1 die bisherigen Zellenfelder 2 bis 9 jeweils in ein erstes und zweites Unterzellenfeld 21, 22 unterteilt sind. Jedes Unterzellenfeld 21, 22 weist einen eigenen Reihendecoder 11 auf. Somit weist jedes Zellenfeld 2 bis 9 einen Zeilendecoder 10 und zwei Reihendecoder 11 auf. Damit ist der Datenzugriff auf die Daten einer Zeilenauswahlleitung schneller, da die Bitleitungen kürzer sind.

Die Zellenfelder 2 bis 9 sind entsprechend der Ausführungsform der Fig. 1 ringförmig um das Anschlussfeld 1 angeordnet. Ein weiterer Unterschied zur Ausführungsform der Fig. 1 besteht in der Anordnung der Bondpads 14. Die erste, zweite, dritte und vierte Reihe 15, 16, 17, 18 der Bondpads 14 ist entsprechend der Fig. 1 angeordnet. Die fünfte und sechste Reihe 19, 20 ist zwar ebenfalls parallel zu den Längskanten angeordnet, weist jedoch einen sehr viel kleineren Abstand zu den Seitenkanten auf und ist zwischen der ersten, zweiten, dritten und vierten Reihe 14, 15, 16, 17, 18 und den Längskanten angeordnet. Auch sind im Anschlussfeld 1 Peripherieschaltungen 23 ausgebildet.

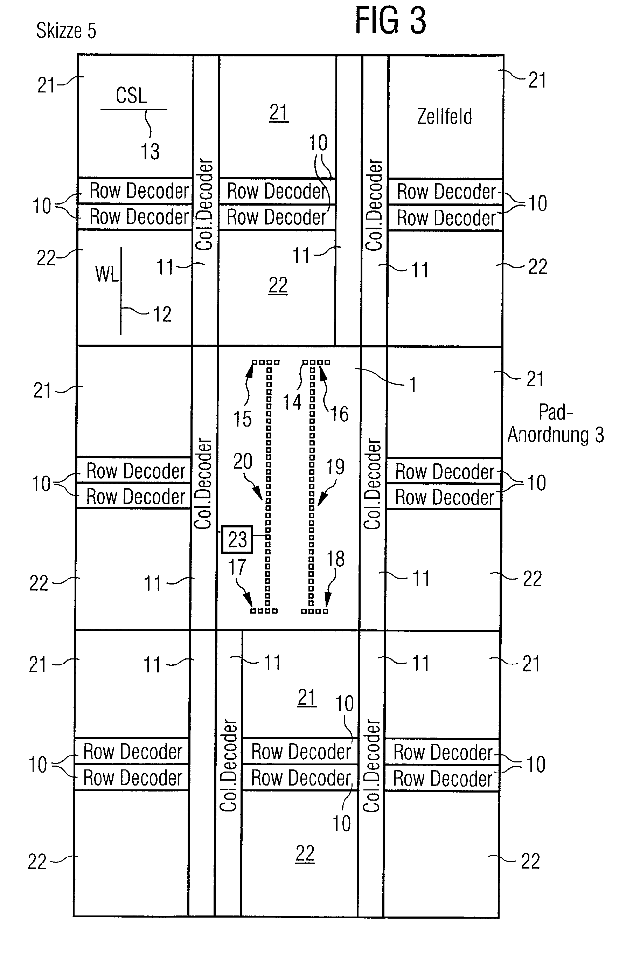

Fig. 3 weist eine weitere Ausführungsform einer Speicheranordnung auf, bei der jedes Zellenfeld 2 bis 9 entsprechend der Ausführungsform der Fig. 2 in ein erstes und zweites Unterzellenfeld 21, 22 unterteilt ist. In dieser Ausführungsform weist jedoch jedes Zellenfeld 2 bis 9 entlang einer Längskante einen Reihendecoder 11 auf. Zudem sind jeweils ein Zeilendecoder 10 für ein Unterzellenfeld 21, 22 in jedem Zellenfeld angeordnet. Ansonsten entspricht der Aufbau der Zellenfelder dem Aufbau der Fig. 2.

Ein weiterer Unterschied zur Fig. 2 besteht in der Anordnung der Bondpads 14 im Anschlussfeld 1. Zwar sind die erste, zweite, dritte und vierte Reihe 14, 15, 16, 17, 18 entsprechend der Fig. 2 angeordnet. Die fünfte und sechste Reihe 19, 20 sind parallel zu den Längskanten ausgebildet. Die fünfte Reihe 19 ist zwischen der zweiten und vierten Reihe 16, 18, die sechste Reihe 20 ist zwischen der ersten und der dritten Reihe 15, 17 angeordnet. Ebenfalls sind im Anschlussfeld 1 Peripherieschaltungen 23 integriert.

Vorzugsweise sind alle Peripherieschaltungen, die zum Betreiben der Speicheranordnung notwendig sind, im ersten Anschlussfeld der Speicheranordnungen der Figuren 1, 2, 3 angeordnet.

## Patentansprüche

1. Speicheranordnung mit einem Anschlussfeld (1) und mit Zellenfeldern (2 bis 9), die an das Anschlussfeld (1) grenzen, wobei ein Zellenfeld (2 bis 9) einen matrixförmigen Speicher mit Zeilen- und Spaltendecodern (10, 11) aufweist, die jeweils mit Adressleitungen (12, 13) verbunden sind,
wobei das Anschlussfeld (1) Anschlusspads aufweist, die mit den Zellenfeldern (2 bis 9) elektrisch verbunden sind, **dadurch gekennzeichnet,**
**dass** das Anschlussfeld (1) mittig angeordnet ist,
**dass** an jeder der vier Seitenkanten des Anschlussfeldes (1) jeweils ein Zellenfeld (2 bis 9) anliegt,
**dass** die Zellenfelder (2 bis 9) in einem geschlossenen Kranz um das Anschlussfeld herum angeordnet sind,
**dass** ein Zellenfeld (2) mit jeweils zwei Seitenkanten an zwei andere Zellenfelder (3,9) angrenzt,
**dass** ein Zellenfeld (2 bis 9) in der Längsrichtung in ein erstes und ein zweites Unterzellenfeld (21, 22) unterteilt ist, dass das erste und das zweite Unterzellenfeld (21, 22) entlang der Längsseite, die an das Anschlussfeld (1) oder ein anderes Zellenfeld (2 bis 9) angrenzt, einen Zeilen- oder Reihendecoder (10, 11) aufweist,
**dass** das Zellenfeld (2 bis 9) in der Mitte der Längsseite zwei aneinander angrenzende Reihen- oder Zeilendecoder (10, 11) aufweist,
**dass** ein erster Reihen- oder Zeilendecoder (10, 11) mit ersten Adressleitungen (12, 13) verbunden ist, die parallel zur Längsrichtung im ersten Unterzellenfeld (21) angeordnet sind,
**dass** ein zweiter Reihen- oder Zeilendecoder (10, 11) mit zweiten Adressleitungen (12,13) verbunden ist, die parallel zur Längsrichtung im zweiten Unterzellenfeld (22) angeordnet sind.

2. Speicheranordnung nach Anspruch 1, **dadurch gekennzeichnet, dass**
das Anschlussfeld (1) rechteckförmig ausgebildet ist,
dass die Zellenfelder (2 bis 9) rechteckförmig ausgebildet sind,
dass an die Seitenkanten des Anschlussfeldes (1) vier Zellenfelder (3, 5, 7, 9) mit je einer Seitenkante angrenzen, deren Länge gleich der Länge der Seitenkanten des Anschlussfeldes (1) ist,
dass in den vier Eckbereichen jeweils ein Zellenfeld (2, 4, 6, 8) angeordnet ist,
dass die Gesamtfläche der Speicheranordnung rechteckförmig ausgebildet ist.

3. Speicheranordnung nach Anspruch 1 oder 2, **dadurch gekennzeichnet, dass** eine fünfte und eine sechste Reihe von Anschlusspads (14) in einem vorgegebenen Abstand parallel zu den Längsseiten des Anschlussfeldes (1) angeordnet sind, dass eine erste, zweite, dritte und vierte Reihe (15, 16, 17, 18) von Anschlusspads in einem vorgegebenen Abstand parallel zu den Querseiten des Anschlussfeldes (1) angeordnet sind,
dass die erste und zweite bzw. die dritte und vierte Reihe auf einer Linie angeordnet sind und einen vorgegebenen Abstand voneinander aufweisen,
dass die fünfte und die sechste Reihe (19, 20) jeweils mittig zu der ersten und dritten bzw. der zweiten und vierten Reihe (15, 17, 16, 18) angeordnet sind.

4. Speicheranordnung nach Anspruch 1 oder 2, **dadurch gekennzeichnet, dass** eine fünfte und eine sechste Reihe von Anschlusspads in einem vorgegebenen Abstand parallel zu den Längsseiten des Anschlussfeldes angeordnet sind,
dass eine erste, zweite, dritte und vierte Reihe von Anschlusspads in einem vorgegebenen Abstand parallel zu den Querseiten des Anschlussfeldes (1) angeordnet sind,
dass die erste und zweite bzw. die dritte und die vierte Reihe (15, 16, 17, 18) auf einer Linie angeordnet sind und einen vorgegebenen Abstand voneinander aufweisen,
dass die fünfte und die sechste Reihe (19, 20) jeweils zwischen der ersten und zweiten bzw. der dritten und vierten Reihe (15, 16, 17, 18) angeordnet sind.

5. Speicheranordnung nach Anspruch 1 oder 2, **dadurch gekennzeichnet, dass** eine fünfte und eine sechste Reihe (19, 20) von Anschlusspads (14) in einem vorgegebenen Abstand parallel zu den Längsseiten des Anschlussfeldes (1) angeordnet sind,
dass eine erste, zweite, dritte und vierte Reihe (15, 16, 17, 18) von Anschlusspads (14) in einem vorgegebenen Abstand parallel zu den Querseiten des Anschlussfeldes (1) angeordnet sind,
dass die erste und zweite bzw. die dritte und vierte Reihe (15, 16, 17, 18) auf einer Linie angeordnet sind und einen vorgegebenen Abstand voneinander aufweisen,
dass die fünfte und die sechste Reihe (19, 20 jeweils zwischen der ersten und dritten bzw. der zweiten und vierten Reihe (15, 17, 16, 18) und den Längskanten des Anschlussfeldes (1) angeordnet sind.

6. Speicheranordnung nach einem der Ansprüche 1 bis 5, **dadurch gekennzeichnet, dass** im Anschlussfeld (1) Peripherieschaltungen (23) zum Betreiben der Zellenfelder (2 bis 9) angeordnet sind.

7. Speicheranordnung nach einem der Ansprüche 1 bis 6, **dadurch gekennzeichnet, dass** ein Zellenfeld (2 bis 9) annähernd die gleiche Größe und Form aufweist wie das Anschlussfeld (1).

8. Speicheranordnung nach einem der Ansprüche 1 bis 6, **dadurch gekennzeichnet, dass** ein Zellenfeld (2 bis 9) in zwei Unterzellenfelder (20, 21) unterteilt ist.

9. Speicheranordnung nach einem der Ansprüche 1 bis 8, **dadurch gekennzeichnet, dass** ein Zellenfeld (2 bis 9) und/oder ein Anschlussfeld (1) doppelt so lang wie breit ausgebildet ist.
